Europäisches Patentamt

(19) European Patent Office

Office européen des brevets

(11) Numéro de publication : **0 239 794 B1**

(12) **FASCICULE DE BREVET EUROPÉEN**

(45) Date de publication du fascicule du brevet :
28.03.90

(21) Numéro de dépôt : 87102751.2

(22) Date de dépôt : 26.02.87

(51) Int. Cl.⁵ : **C 30 B 29/06, C 30 B 13/22, C 30 B 13/00**

(54) Procédé d'obtention de cristaux de silicium pour applications photovoltaïques.

(30) Priorité : 27.02.86 FR 8602736

(43) Date de publication de la demande :
07.10.87 Bulletin 87/41

(45) Mention de la délivrance du brevet :
28.03.90 Bulletin 90/13

(84) Etats contractants désignés :
AT BE CH DE ES FR GB GR IT LI LU NL SE

(56) Documents cités :
EP—A— 0 045 689
DE—A— 3 112 879
DE—B— 1 215 111
FR—A— 2 438 499

(73) Titulaire : PHOTOWATT INTERNATIONAL S.A.
125, rue du Président Wilson
F-92302 Levallois-Perret (FR)

(72) Inventeur : Amouroux, Jacques
13b rue de Villeziers
F-91440 Bures sur Yvette (FR)
Inventeur : Morvan, Daniel
16, rue du Sommerard
F-75005 Paris (FR)
Inventeur : Apostolidou, Hélène
50, rue Marcelin Berthelot
F-94140 Alfortville (FR)
Inventeur : Slootman, Frank
8 avenue Lavoisier
F-92500 Ruell Malmaison (FR)

(74) Mandataire : Weinmiller, Jürgen et al
Lennéstrasse 9 Postfach 24
D-8133 Feldafing (DE)

EP 0 239 794 B1

Jouve, 18, rue St-Denis, 75001 Paris, France

## Description

La présente invention concerne un procédé d'obtention de cristaux de silicium pour applications photovoltaïques.

D'après l'enseignement des brevets français n° 2 438 499 du 13 octobre 1978, n° 2 455 921 du 8 mai 1979, et n° 2 487 808 du 1er août 1980, on sait purifier du silicium métallurgique en vue d'applications photovoltaïques, en dirigeant sur le lingot à purifier un jet de plasma chaud obtenu par excitation haute fréquence ; on déplace l'un par rapport à l'autre le jet et le lingot pour faire circuler la zone fondue le long du lingot. Le gaz utilisé est constitué d'un mélange d'argon, d'hydrogène et d'oxygène, la teneur en oxygène étant suffisamment faible pour ne pas oxyder le silicium de façon appréciable.

A titre d'exemple, on traite par le procédé précédent un lingot de silicium métallurgique à 2 % d'impuretés qui sont réparties comme indiqué dans le tableau I ci-après :

Tableau I

| Nature de l'impureté | taux | Nature de l'impureté | taux |
|---|---|---|---|
| Al | 3000 ● | Mn | 43 |
| As | 0.08 | Mo | 10 |
| Ag | 0.2 | Na | 7.8 |
| Ba | 20 | Ni | 80 |
| C | 1900 ● | O | 4000 ● |
| Ca | 2000 ● | Sb | 0.07 |
| Co | 5 | Sc | 0.62 |
| Cr | 40 | Ta | 0.002 |
| Cu | 40 | Ti | 160 ● |
| Fe | 1800 ● | Zn | 40 |
| Ga | 1.5 | Zr | 0.3 |
| La | 10 | | |

Les taux sont exprimés en ppm atomiques, l'analyse ayant été faite par radioactivation.

Les nombres assortis d'un astérisque correspondent à une analyse par spectrométrie de masse.

On observe après plusieurs traitements de purification que bon nombre des impuretés ont été éliminées du lingot, mais que son rendement de conversion photovoltaïque ne dépasse pas 7 %. On rappelle que le rendement de conversion photovoltaïque ($\eta$) est le rapport entre la puissance électrique maximale de sortie et le produit de la surface du dispositif photovoltaïque par l'éclairement incident mesuré dans des conditions d'essai définies, ce rapport étant exprimé sous forme de pourcentage (cf. terminologie CEI, CT 82, Systèmes photovoltaïques).

Le but de la présente invention est d'obtenir, de manière économique, du silicium destiné à des applications photovoltaïques, et présentant un rendement de conversion photovoltaïque au moins égal à 10 %.

On a découvert que, d'une manière surprenante, on pouvait obtenir un tel résultat en traitant par le procédé de fusion précédemment décrit, non pas de silicium métallurgique, mais des rejets de silicium de type P ou de N, tels que des rejets de l'industrie électronique, ou des rebuts issus des procédés de cristallisation du silicium, à condition que leur résistivité soit au moins égale à 0,05 ohm.cm.

D'autres caractéristiques et avantages de la présente invention apparaîtront au cours de la description suivante d'exemples de mise en œuvre du procédé selon l'invention, donnés à titre illustratif mais nullement limitatif.

## Exemple 1

On part d'un rejet quelconque de silicium de l'industrie électronique.

On lui applique un traitement de recristalliation par le procédé dit « POLYX ». Ce procédé est décrit notamment par « 1985. Photovoltaïc Solar Energie » relatant la conférence de Londres (15-19 avril 1985), dans un article intitulé « Growth of silicon ingots by the POLYX PROCESS ».

Après ce traitement on a un échantillon dont la résistivité est de 0,065 ohm.cm et dont le rendement photovoltaïque η est nul. Après une fusion par plasma selon le procédé précité, on obtient un rendement η égal à 11,5 %.

Exemple 2

On part d'un déchet de l'industrie électronique constitué d'une plaque de silicium ayant subi une oxydation. Après traitement de fusion par plasma le rendement η devient égal à 11,2 %.

Exemple 3

On prend du silicium de qualité électronique dégradé et on l'utilise dans le procédé POLYX. La résistivité est alors de 1 ohm.cm et le rendement η de 9,5 %. Après une fusion par plasma, ce rendement devient égal à 10,9 %.

Exemple 4

On part d'un matériau issu d'une recristallisation par le procédé POLYX. Le matériau est de type N et sa résistivité est voisine de 7 ohm.cm. Après une fusion par plasma selon le procédé précité, le rendement photovoltaïque η est de 10,36 % et la résistivité de type P égale à 2 ohm.cm.

Le matériau purifié a été analysé par activation neutronique. Les résultats sont consignés dans le tableau II suivant :

Tableau II

| Nature de l'impureté | Tête du barreau taux en $\mu g/g$ | Queue du barreau Taux en $\mu g/g$ |
|---|---|---|
| As | <0.002 | <0.003 |
| Au | <0.00007 | <0.0006 |
| Ag | <0.005 | <0.006 |
| Co | <0.004 | <0.0009 |
| Cr | <0.005 | <0.008 |
| Cs | <0.005 | <0.007 |
| Cu | 0.008 + 0.003 | 0.007 + 0.002 |
| Fe | <0.11 | <0.3 |
| Ga | <0.007 | <0.004 |
| Hf | <0.002 | <0.003 |
| K | <0.5 | <0.09 |
| Mn | <0.006 | <0.09 |
| Na | <0.003 | <0.004 |
| Ni | <0.09 | <0.1 |
| Sb | <0.0005 | <0.002 |
| Sc | <0.00007 | <0.006 |
| Ta | <0.0002 | <0.001 |
| W | <0.0007 | <0.008 |
| Zn | <0.04 | <0.03 |
| Zr | <0.009 | <0.2 |

3

Le procédé selon l'invention présente un avantage économique énorme car il permet d'utiliser certains rebuts de l'industrie habituellement détruits et d'obtenir un composant de bonne qualité et beaucoup moins coûteux pour les cellules photovoltaïques.

**Revendications**

1. Procédé d'obtention de cristaux de silicium pour applications photovoltaïques et présentant un rendement de conversion photovoltaïque au moins égal à 10 % selon lequel on réalise une purification du silicium par passage dans un jet de plasma, à partir de déchets de silicium recyclables de type P ou de type N, mono ou polycristallins présentant un taux d'impuretés et un état de cristallisation tels que leur résistivité soit au moins égale à 0.05 ohm.cm.

2. Procédé selon la revendication 1, caractérisé par le fait que lesdits déchets sont constitués par des rebuts de l'industrie électronique ou photovoltaïque sous forme de plaquettes de silicium.

3. Procédé selon la revendication 1, caractérisé par le fait que lesdits déchets sont constitués par des rebuts de l'industrie électronique ou photovoltaïque sous forme de boues de sciage.

**Claims**

1. A method of obtaining silicon crystals for photovoltaic applications and having a photovoltaic conversion efficiency of not less than 10 %, in which the silicon is purified by passing through a plasma jet, the starting material being constituted by monocrystalline or polycrystalline P-type or N-type recyclable silicon waste having a concentration of impurities and a crystallization state such that its resistivity is not less than 0,05 ohm.cm.

2. A method according to claim 1, characterized in that said waste is constituted by plates of silicon rejected by the electronics industry or the photovoltaic industry.

3. A method according to claim 1, characterized in that said waste is constituted by reject silicon sawdust sludge from the electronics industry or the photovoltaic industry.

**Patentansprüche**

1. Verfahren zur Gewinnung von Siliziumkristallen für photovoltaische Anwendungen und mit einem photovoltaischen Umwandlungswirkungsgrad von mindestens 10 %, bei welchem eine Reinigung des Siliziums aus wiederaufbereitbaren mono- oder polykristallinen Siliziumabfällen vom Typ P oder N durch Hindurchführen durch einen Plasmastrahl bewirkt wird, wobei die Abfälle eine Konzentration an Verunreinigungen und einen Kristallisationszustand solcher Art besitzen, daß ihr spezifischer Widerstand mindestens 0,05 ohm.cm beträgt.

2. Verfahren nach Anspruch 1, dadurch gekennzeichnet, daß die Abfälle aus Abfällen der elektronischen oder der photovoltaischen Industrie in Form von Siliziumplättchen bestehen.

3. Verfahren nach Anspruch 1, dadurch gekennzeichnet, daß die Abfälle aus Abfällen der elektronischen oder photovoltaischen Industrie in Form von Sägeschlämmen bestehen.

4